# FASCICULE DE BREVET EUROPEEN

(11) **EP 4 508 445 B1**
(45) Date de publication et mention de la délivrance du brevet: **15.04.2026**
(21) Numéro de dépôt: 23709253.1
(22) Date de dépôt: 16.02.2023
(51) Int. Cl.: G01R 31/00, G01R 31/327, H01M 50/574, H01M 10/42

(54) **PROCEDE DE DETECTION D'UN ETAT FERME BLOQUE D'UN ORGANE INTERMEDIAIRE DE COUPURE DE COURANT ELECTRIQUE AGENCE AU SEIN D'UNE BATTERIE ELECTRIQUE D'UN VEHICULE**
VERFAHREN ZUR ERKENNUNG EINES BLOCKIERTEN GESCHLOSSENEN ZUSTANDS EINES IN EINER ELEKTRISCHEN BATTERIE EINES FAHRZEUGS ANGEORDNETEN ELEKTRISCHEN STROMUNTERBRECHERS
METHOD FOR DETECTING A BLOCKED CLOSED STATE OF AN INTERMEDIATE ELECTRICAL CURRENT-BREAKING MEMBER ARRANGED WITHIN AN ELECTRIC BATTERY OF A VEHICLE

(30) Priorité: 15.04.2022 FR 2203502
(43) Date de publication de la demande: 19.02.2025
(73) Titulaire: Stellantis Auto SAS, 78300 Poissy (FR)
(72) Inventeur: MIZWICKI, Eric, 95180 Menucourt (FR); VIOLLIN, Pierre-Mikael, 78000 Versailles (FR); GILLE, Jerome, 78180 Montigny-le-Bretonneux (FR)
(74) Mandataire: PSIP
(86) Numéro de dépôt international: PCT/FR2023/050211
(87) Numéro de publication internationale: WO 2023/198964

(56) Documents cités:
- JP-A- 2013 076 602
- US-A1- 2016 377 667

## Description

L'invention se rapporte à un procédé de détection d'un état fermé bloqué d'un organe intermédiaire de coupure de courant électrique agencé au sein d'une batterie électrique d'un véhicule. Le véhicule est en particulier un véhicule électrique ou hybride. Le procédé est mis en œuvre par une unité de commande de la batterie électrique. La batterie électrique (aussi appelée bloc batterie ou « battery pack » en anglais) est une batterie de traction du véhicule électrique ou hybride, notamment une batterie lithium-ion.

L'invention appartient au domaine des batteries de stockage électrique pour véhicules électrique ou hybrides. Une batterie électrique comprend classiquement un ensemble de modules de stockage d'énergie électrique reliés en série, chaque module de stockage d'énergie électrique comportant plusieurs cellules de stockage d'énergie électrique. Dans le cas d'une batterie électrique de traction du véhicule, la batterie électrique comprend également une borne de conduction positive et une borne de conduction négative reliées à un groupe motopropulseur électrique de traction du véhicule via un convertisseur de tension réversible du véhicule couplant une première tension de la batterie avec une seconde tension d'un réseau électrique du véhicule. La batterie électrique comprend également un premier organe de coupure de courant électrique et un second organe de coupure de courant électrique. Le premier organe de coupure de courant électrique (typiquement un relais électromécanique) est connecté en série entre la borne de conduction positive de la batterie électrique et un premier module de stockage d'énergie électrique situé à une première extrémité de l'ensemble de modules. Le second organe de coupure de courant électrique (typiquement un relais électromécanique) est connecté en série entre la borne de conduction négative de la batterie électrique et un le dernier module de stockage d'énergie électrique situé à une seconde extrémité de l'ensemble de modules. Les premier et second organes de coupure de courant électrique permettent de connecter électriquement la batterie électrique au groupe motopropulseur électrique de traction du véhicule, et de fournir ainsi de l'énergie électrique au groupe motopropulseur électrique.

L'emballement thermique d'une batterie électrique, en particulier d'une batterie lithium-ion, est un phénomène bien connu au cours duquel une élévation de température au sein d'une ou plusieurs cellule(s) de la batterie entraîne une série de réactions en chaîne pendant lesquelles différents constituants internes de la ou des cellule(s) sont décomposés. Si la chaleur évacuée est inférieure à la chaleur produite, ces réactions s'enchainent et le système s'auto-entretient jusqu'à une montée brutale de la température qui n'est plus maîtrisable. Du fait de son étanchéité, la cellule monte en pression jusqu'à s'ouvrir en libérant l'électrolyte sous forme de gaz très chauds et inflammables, conduisant généralement à un feu avec émanation de fumées toxiques du fait de la présence de composés fluorés.

Il est connu des systèmes permettant de détecter l'apparition d'un tel emballement thermique au sein d'une batterie de stockage électrique, notamment au sein d'une batterie électrique installée dans un véhicule. Certains de ces systèmes sont configurés pour détecter une chute brutale de la tension électrique du courant délivré par la batterie électrique.

Les documents brevets CN 110943261 A et JP 2013 076602 A décrivent par exemple un tel système de détection. Le système comporte une première unité de surveillance de l'emballement thermique au sein d'une batterie au lithium-ion, où les conditions ou risques d'emballement thermique de la batterie sont surveillés en temps réel grâce à un algorithme réglé en fonction d'un signal de température, d'un signal de tension électrique et d'un signal de courant électrique de la batterie. Une deuxième unité est également utilisée pour envoyer un signal d'alerte précoce d'emballement thermique, et une troisième unité envoie l'information dans un réseau informatique « en nuage » (ou « cloud » en anglais). La détection est effectuée en surveillant une éventuelle chute de la tension électrique pendant la charge à tension constante et à courant constant de la batterie. Toutefois, la détection d'une telle chute de tension n'est pas nécessairement indicative de l'apparition d'un emballement thermique au sein de la batterie électrique, car cette chute de tension peut être déclenchée pour d'autres raisons (telle que notamment l'activation de certains dispositifs de consommation électrique au sein du véhicule). La détection mise en œuvre par un tel système est par conséquent peu fiable.

D'autres de ces systèmes sont configurés pour détecter une augmentation brutale de la pression gazeuse au niveau de la batterie électrique. Bien que la détection effectuée par ces systèmes soit relativement fiable, celle-ci est réalisée très tardivement : en effet, au moment de la détection de l'emballement thermique par le système, la batterie électrique est déjà très proche d'entrer en combustion. Ceci pose donc des problèmes en termes de protection de la batterie électrique et de sécurité pour le véhicule au sein duquel elle est installée. D'autres systèmes encore sont basés sur une mesure de la température des modules de la batterie électrique, via un ou plusieurs capteurs thermiques. Toutefois, la détection effectuée par ces systèmes n'est pas fiable parce que le capteur thermique se situe sur l'extérieur du module, alors que la résistance et la capacité thermique de la batterie a pour conséquence une température beaucoup plus élevée à l'intérieur de la batterie. Or, le lien entre la température mesurée et la température à l'intérieur de la batterie n'a pas fiable en raison de l'indisponibilité de la modélisation thermique de la batterie. D'autres systèmes enfin utilisent des capteurs à fibre optique embarqués dans le cœur des cellules de stockage d'énergie électrique qui composent la batterie électrique. Toutefois, de tels systèmes impactent fortement la fabrication de la batterie et ne sont donc pas industrialisables.

D'autres systèmes connus permettent de protéger la batterie électrique et son environnement contre la survenue d'un tel emballement thermique. En particulier, dans le cadre de nouvelles normes relatives à la détection de l'apparition d'un emballement thermique au sein d'une batterie de stockage électrique (de telles normes imposant de prévenir l'utilisateur du véhicule de l'apparition de l'emballement thermique cinq minutes avant l'apparition des premières fumées dans l'habitacle - par exemple via une alerte au tableau de bord du véhicule), il est connu d'ajouter un organe intermédiaire de coupure de courant électrique entre les premier et second organes de coupure de courant électrique (selon la configuration de la batterie électrique), afin d'interrompre plus efficacement la propagation de l'emballement thermique et de permettre ainsi de respecter voire de dépasser les exigences normatives sur le sujet.

Une solution sécurisée consiste à utiliser un relais électromécanique pour assurer cette fonction d'organe intermédiaire de coupure de courant électrique. Le relais électromécanique est connecté en série entre deux modules de stockage d'énergie électrique de la batterie, et la supervision du relais électromécanique est alors assurée par un système de gestion de la batterie électrique (aussi appelé système BMS, de l'anglais « Battery Management System »). Cette solution permet d'assurer une certaine sécurité (car le relai est en position naturellement ouverte pour garantir la tenue de l'exigence normative, même lorsque le système de gestion de la batterie est en mode endormi). Le système BMS est relié aux premier et second organes de coupure de courant électrique, à l'organe intermédiaire de coupure de courant électrique et au convertisseur de tension réversible. Il existe alors un besoin de pouvoir diagnostiquer de manière fiable l'état « relais fermé bloqué » pour l'organe intermédiaire de coupure de courant électrique, car une telle configuration représente une perte directe de barrière de sécurité pour le système, et donc un risque élevé de propagation incontrôlée de l'emballement thermique.

Pour les premier et second organes de coupure de courant électrique, les diagnostics des cas de défaillance « relais ouvert bloqué » et « relais fermé bloqué » sont habituellement réalisés de la manière suivante :
- pour le premier organe de coupure de courant électrique : une comparaison des tensions électriques en amont et aval du relais. Cette solution implique deux mesures de tension par le système BMS ;
- pour le second organe de coupure de courant électrique : une relecture de l'état du relais via l'injection d'un courant électrique et la relecture de l'information pour déterminer l'état du relais.

Toutefois, les solutions citées ci-dessus pour le diagnostic des relais des premier et second organes de coupure de courant électrique sont insatisfaisantes pour le diagnostic de l'état « fermé bloqué » de l'organe intermédiaire de coupure de courant électrique, et ce pour les raisons suivantes :
- la solution consistant à ajouter une mesure de tension en aval du relais ne peut pas fonctionner car la tension équivalente sera vue de manière identique que le relais soit ouvert ou fermé : cette tension « passe » en effet par un organe de mesure des tensions électriques aux bornes des cellules de stockage d'énergie électrique (appartenant par exemple à un composant contrôleur de gestion de cellules CMC, de l'anglais « Cell Monitoring Controller ») ;
- la solution par injection d'un courant électrique, si elle pourrait fonctionner techniquement, impose toutefois d'installer de nouveaux composants dans l'unité de gestion du système BMS, impliquant une hausse des coûts de production du système, et imposant en outre le passage d'un fil comprenant de la basse tension (donc dangereuse pour l'homme) depuis le milieu de la batterie électrique jusqu'à l'unité de gestion du système BMS, ce qui représente une très forte contrainte pour la sécurité du montage.

Le but de l'invention est de pallier les inconvénients de l'art antérieur en proposant un procédé de détection d'un état fermé bloqué d'un organe intermédiaire de coupure de courant électrique agencé au sein d'une batterie électrique d'un véhicule électrique ou hybride, qui soit simple, sécurisé et fiable, et qui ne nécessite pas de recourir à un ou plusieurs composant(s) additionnel(s) ni d'ajouter quelque contrainte sécuritaire que ce soit sur le montage.

Pour ce faire, l'invention se rapporte ainsi, dans son acceptation la plus large, à un procédé de détection d'un état fermé bloqué d'un organe intermédiaire de coupure de courant électrique d'une batterie électrique d'un véhicule, la batterie électrique comprenant :
- l'organe intermédiaire de coupure de courant électrique,
- une borne positive et une borne négative reliées à un convertisseur de tension réversible du véhicule couplant une première tension de la batterie avec une seconde tension d'un réseau électrique du véhicule,
- un ensemble de modules de stockage d'énergie électrique reliés en série, chaque module de stockage d'énergie électrique comportant plusieurs cellules de stockage d'énergie électrique, l'organe intermédiaire de coupure de courant électrique étant connecté en série entre deux modules intermédiaires de stockage d'énergie électrique,
- un premier organe de coupure de courant électrique connecté en série entre l'ensemble des modules et la borne positive, et
- un second organe de coupure de courant électrique connecté en série entre l'ensemble des modules et la borne négative,
le véhicule comprenant en outre une unité de commande de la batterie électrique et des organes de coupure propre à mettre en œuvre le procédé et comprenant un organe de mesure des tensions électriques aux bornes des cellules de stockage d'énergie électrique, l'organe intermédiaire de coupure de courant électrique et le premier organe de coupure de courant électrique étant initialement fermés, le procédé exécutant les étapes successives suivantes :
- une commande de fonctionnement du convertisseur élevant la tension du réseau électrique à une valeur légèrement supérieure à celle de la batterie électrique, pour une valeur consigne de tension prédéterminée et pour une durée prédéterminée, puis pendant cette durée :
   o une mesure d'une valeur de tension électrique aux bornes de l'organe intermédiaire de coupure de courant électrique, puis
   o une comparaison entre la valeur de tension électrique mesurée d'une part, et une valeur de tension prédéterminée d'autre part ; puis
   o en fonction du résultat de la comparaison, une détermination d'un état fermé bloqué de l'organe intermédiaire de coupure de courant électrique,
la valeur consigne de tension prédéterminée se décomposant comme une somme d'une première valeur consigne de tension prédéterminée et d'une seconde valeur consigne de tension prédéterminée, la première valeur consigne de tension prédéterminée étant égale à la valeur de tension nominale de la batterie électrique, et la valeur de tension prédéterminée utilisée lors de l'étape de comparaison est égale à la seconde valeur consigne de tension prédéterminée, l'unité de commande de la batterie électrique détectant un état fermé bloqué de l'organe intermédiaire de coupure de courant électrique si la valeur de tension électrique mesurée aux bornes de l'organe intermédiaire de coupure de courant électrique est inférieure à la valeur de tension prédéterminée, en particulier si la valeur de tension électrique mesurée aux bornes de l'organe intermédiaire de coupure de courant électrique est nulle.

Le procédé selon l'invention offre un moyen de détection simple, sécurisé et fiable. En outre, en utilisant un convertisseur de tension réversible (dans son mode élévateur, ou inversé) déjà présent dans tout système d'alimentation électrique d'un véhicule électrique ou hybride, le procédé selon l'invention ne requiert pas de recourir à un ou plusieurs composant(s) additionnel(s) pour effectuer la détection, ni d'ajouter quelque contrainte sécuritaire que ce soit sur le montage. Ceci permet de réduire les coûts de fabrication ainsi que les coûts de développement, tout en garantissant de respecter les normes relatives à la détection de l'apparition d'un emballement thermique au sein de la batterie. Ceci permet d'améliorer la fiabilité de la détection de l'état fermé bloqué de l'organe intermédiaire de coupure de courant électrique. En effet, la valeur de tension électrique mesurée par l'organe de mesure des tensions électriques aux bornes de l'organe intermédiaire de coupure de courant électrique est égale à la seconde valeur consigne de tension prédéterminée si et seulement si l'organe intermédiaire de coupure de courant électrique est ouvert. Dans le cas contraire, le procédé détecte que l'organe intermédiaire de coupure de courant électrique est dans l'état fermé bloqué.

Selon une caractéristique technique particulière de l'invention, la seconde valeur consigne de tension prédéterminée et/ou la durée prédéterminée sont calibrables par un utilisateur.

De préférence, la seconde valeur consigne de tension prédéterminée est égale à + 5V. Une telle valeur de + 5V permet de calibrer de manière optimale la détection de l'état fermé bloqué de l'organe intermédiaire de coupure de courant électrique, en fonction de la précision de la mesure de tension de chaque barre de distribution de courant reliant deux modules de la batterie (afin de garantir de bien distinguer l'état ouvert de l'état fermé). L'organe intermédiaire de coupure de courant électrique étant connecté entre deux modules de la batterie électrique, sur une des barres de distribution de courant, cette valeur de + 5V qui correspond au maximum de la tension de chaque barre de distribution de courant permet en effet de maximiser la différence entre la tension mesurée pour l'état ouvert d'une part et la tension mesurée pour l'état fermé d'autre part. Ceci permet ainsi d'améliorer encore la fiabilité de la détection.

Selon une caractéristique technique particulière de l'invention, le procédé comporte en outre une étape mise en sommeil de l'unité de commande, ladite étape de mise en sommeil étant effectuée en fonction du résultat de la comparaison. Cette étape de mise en sommeil est par exemple mise en œuvre si la valeur de tension électrique mesurée aux bornes de l'organe intermédiaire de coupure de courant électrique est égale à la valeur de tension prédéterminée. Dans ce cas en effet, aucun défaut de type « relais intermédiaire à l'état fermé bloqué » n'est détecté par l'unité de commande de la batterie électrique.

Selon une autre caractéristique technique particulière de l'invention, l'organe intermédiaire de coupure de courant électrique et les premier et second organes de coupure de courant électrique sont des relais électromécaniques.

On décrira ci-après, à titre d'exemples non limitatifs, des formes d'exécution de la présente invention, en référence aux figures annexées sur lesquelles :

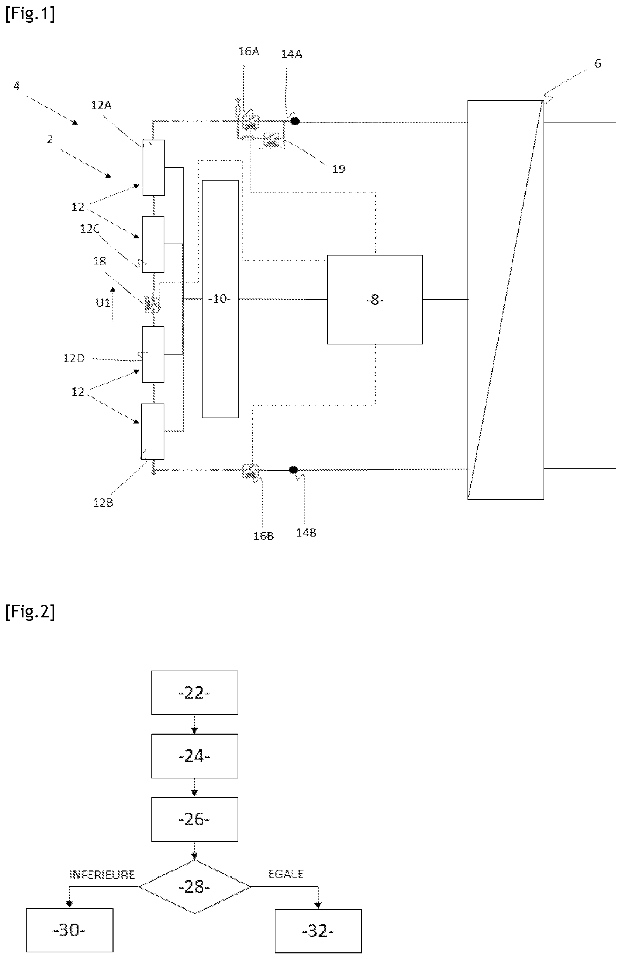

[Fig.1] illustre schématiquement un ensemble comprenant une batterie électrique d'un véhicule électrique ou hybride, la batterie électrique comprenant un premier organe de coupure de courant électrique, un second organe de coupure de courant électrique et un organe intermédiaire de coupure de courant électrique ;
[Fig.2] est un organigramme représentant un procédé de détection d'un état fermé bloqué de l'organe intermédiaire de coupure de courant électrique de la figure 1 selon la présente invention ; et

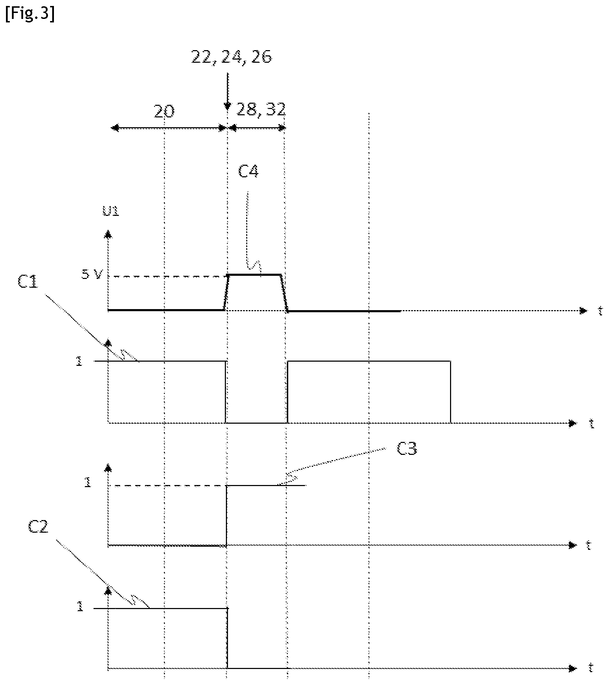

[Fig.3] est un ensemble de quatre diagrammes, trois de ces diagrammes représentant respectivement l'évolution, en fonction du temps, de l'état ouvert ou fermé des premier et second organes de coupure de courant électrique et de l'organe intermédiaire de coupure de courant électrique, selon différentes phases du procédé de la figure 2, le quatrième diagramme représentant l'évolution, en fonction du temps, d'une tension électrique mesurée aux bornes de l'organe intermédiaire de coupure de courant électrique, selon différentes phases du procédé de la figure 2.

En se référant à la figure 2 la présente invention concerne un procédé de détection d'un état fermé bloqué d'un organe intermédiaire de coupure de courant électrique agencé au sein d'une batterie électrique d'un véhicule (notamment d'un véhicule électrique ou hybride). La batterie électrique est une batterie de traction du véhicule électrique ou hybride, notamment une batterie lithium-ion. Sur la figure 1 sont représentés une batterie électrique 2 et un ensemble 4 installés dans un véhicule (non représenté). L'ensemble 4 comporte un convertisseur 6 d'une première tension électrique continue en une seconde tension électrique continue, et une unité 8 de commande de la batterie électrique 2. L'unité de commande 8 comporte un organe 10 de mesure de tensions électriques aux bornes de cellules de stockage d'énergie électrique de la batterie électrique 2.

La batterie électrique 2 comporte par exemple un boîtier (non représenté) renfermant un ensemble de modules de stockage d'énergie électrique 12 reliés en série. Chaque module de stockage d'énergie électrique 12 comporte typiquement plusieurs cellules de stockage d'énergie électrique (de telles cellules n'étant pas représentées sur les figures pour des raisons de clarté). La batterie électrique 2 comporte également une borne de conduction positive 14A, une borne de conduction négative 14B, un premier organe de coupure de courant électrique 16A, un second organe de coupure de courant électrique 16B, et un organe intermédiaire de coupure de courant électrique 18. De préférence, comme illustré sur la figure 1, la batterie électrique comporte également un relais électromécanique 19 de pré-charge du premier organe de coupure de courant électrique 16A.

Les bornes de conduction positive et négative 14A, 14B sont reliées à un groupe motopropulseur électrique de traction du véhicule (non représenté), via le convertisseur 6 d'une première tension électrique continue en une seconde tension électrique continue. La batterie électrique 2 fournit un circuit d'alimentation électrique au groupe motopropulseur électrique, présentant une tension électrique nominale par exemple égale à 300 V. Le premier organe de coupure de courant électrique 16A est connecté en série entre la borne de conduction positive 14A et un premier module de stockage d'énergie électrique 12A situé à une première extrémité de l'ensemble de modules 12. Le second organe de coupure de courant électrique 16B est connecté en série entre la borne de conduction négative 14B et un deuxième module de stockage d'énergie électrique 12B situé à une seconde extrémité de l'ensemble de modules 12. Les premier et second organes de coupure de courant électrique 16A, 16B permettent de connecter électriquement la batterie électrique 2 au groupe motopropulseur électrique de traction du véhicule, et de fournir ainsi de l'énergie électrique au groupe motopropulseur électrique. L'organe intermédiaire de coupure de courant électrique 18 est connecté en série entre deux modules de stockage d'énergie électrique 12, de préférence entre deux modules intermédiaires de stockage d'énergie électrique 12C, 12D. Les premier et second organes de coupure de courant électrique 16A, 16B et l'organe intermédiaire de coupure de courant électrique 18 présentent chacun deux états : un état ouvert et un état fermé. Dans l'exemple de réalisation particulier illustré sur la figure 1, les premier et second organes de coupure de courant électrique 16A, 16B et l'organe intermédiaire de coupure de courant électrique 18 sont des relais électromécaniques. Le relais électromécanique de pré-charge 19 est connecté en parallèle du premier organe de coupure de courant électrique 16A.

Le convertisseur 6 est un convertisseur de tension réversible couplant une première tension de la batterie 2 avec une seconde tension d'un réseau électrique du véhicule. Le convertisseur 6 est apte à fonctionner alternativement en mode abaisseur ou en mode élévateur. Le convertisseur 6 abaisse la tension électrique d'un courant électrique continu issu de la batterie électrique 2 dans son mode abaisseur (pour l'alimentation électrique du groupe motopropulseur électrique) et augmente la tension électrique d'un courant électrique continu destiné à recharger électriquement la batterie électrique 2 dans son mode élévateur (un tel courant électrique étant par exemple issu d'une batterie auxiliaire basse tension du véhicule, typiquement une batterie présentant une tension nominale sensiblement égale à 12 V ou 48 V).

L'unité 8 de commande de la batterie électrique 2 est également apte à commander les organes de coupure 16A, 16B, 18. L'unité de commande 8 est par exemple un système de gestion BMS de la batterie électrique 2. L'unité de commande 8 est reliée à l'organe intermédiaire de coupure de courant électrique 18 et aux premier et second organes de coupure de courant électrique 16A, 16B, pour leur commande en ouverture et en fermeture. L'unité de commande 8 est également reliée au convertisseur 6 d'une première tension électrique continue en une seconde tension électrique. L'unité de commande 8 est configurée en outre pour mesurer directement la tension électrique entre le premier organe de coupure de courant électrique 16A et le second organe de coupure de courant électrique 16B. L'unité de commande 8 se présente par exemple sous la forme d'un circuit intégré dédié.

L'organe 10 de mesure de tensions électriques aux bornes des cellules de stockage d'énergie électrique de la batterie électrique 2 est notamment configuré pour mesurer (ou approximer) la tension électrique U1 aux bornes de l'organe intermédiaire de coupure de courant électrique 18, via une mesure d'une différence de tensions électriques entre les deux cellules de stockage d'énergie électrique les plus proches de l'organe intermédiaire de coupure de courant électrique 18, les deux cellules appartenant à des modules intermédiaires de stockage d'énergie électrique 12C-12D distincts. La mesure de la tension électrique U1 aux bornes de l'organe intermédiaire de coupure de courant électrique 18 qui est effectuée par l'organe 10 de mesure de tensions électriques est par conséquent une mesure indirecte de tension. L'organe 10 de mesure de tensions électriques appartient par exemple à un ou plusieurs composant(s) contrôleur(s) de gestion de cellules CMC (de l'anglais « Cell Monitoring Controller »). Chaque composant CMC (non représenté sur les figures) permet un équilibrage des modules 12 de la batterie électrique 2, ainsi qu'une régulation de la température des modules 12. Chaque composant CMC se présente par exemple sous la forme d'un circuit intégré dédié(s).

Au cours d'une phase initiale 20 (visible sur la figure 3), l'organe intermédiaire de coupure de courant électrique 18 et le premier organe de coupure de courant électrique 16A sont fermés. Cette phase initiale 20 de l'organe intermédiaire de coupure de courant électrique 18 et du premier organe de coupure de courant électrique 16A est illustrée sur les courbes C1 et C2 de la figure 3 (qui représentent l'état fermé « 1 » ou ouvert « 0 » de l'organe intermédiaire de coupure de courant électrique 18 et du premier organe de coupure de courant électrique 16A, en fonction du temps). A l'issue de la phase initiale 20, l'organe intermédiaire de coupure de courant électrique 18 et le premier organe de coupure de courant électrique 16A sont commandés en ouverture par l'unité de commande 8. Le premier organe de coupure de courant électrique 16A s'ouvre alors (et le relais de pré-charge 19 se ferme), ce qui est illustré sur la courbe C2 de la figure 3 (et sur une courbe C3 représentant l'état fermé « 1 » ou ouvert « 0 » du relais de pré-charge 19).

Comme illustré sur la figure 2, le procédé de détection comporte de préférence une première étape 22 au cours de laquelle l'unité de commande 8 détecte une valeur de tension prédéfinie entre le premier organe de coupure de courant électrique 16A et le second organe de coupure de courant électrique 18A. La valeur de tension prédéfinie est par exemple une valeur de tension nulle (donc égale à 0 V). Cette première étape de détection 22 permet d'initialiser le procédé.

Le procédé comporte une étape suivante 24 au cours de laquelle l'unité de commande 8 transmet au convertisseur 6 une commande de fonctionnement du convertisseur 6 dans son mode élévateur, à une valeur consigne de tension prédéterminée et pour une durée prédéterminée. Le convertisseur 6 augmente alors, pendant la durée prédéterminée, la tension électrique d'un courant électrique continu destiné à recharger électriquement la batterie électrique 2 (un tel courant électrique étant par exemple issu d'une batterie auxiliaire basse tension du véhicule, typiquement une batterie présentant une tension nominale sensiblement égale à 12 V ou 48 V), la tension étant augmentée à la valeur consigne de tension prédéterminée. Selon un exemple de réalisation préférentiel de l'invention, la valeur consigne de tension prédéterminée se décompose comme une somme d'une première valeur consigne de tension prédéterminée et d'une seconde valeur consigne de tension prédéterminée. La première valeur consigne de tension prédéterminée est égale à la valeur de tension nominale de la batterie électrique (par exemple égale à 300 V). De préférence, la seconde valeur consigne de tension prédéterminée est égale à + 5V. La seconde valeur consigne de tension prédéterminée et/ou la durée prédéterminée sont avantageusement calibrables par un utilisateur.

Le procédé exécute des étapes 26, 28, 30, 32 pendant la durée prédéterminée.

Plus précisément, le procédé comporte une étape suivante 26 au cours de laquelle l'organe 10 de mesure des tensions électriques mesure la valeur de tension électrique U1 aux bornes de l'organe intermédiaire de coupure de courant électrique 18, par mesure d'une différence de tensions électriques entre les deux cellules de stockage d'énergie électrique les plus proches de l'organe intermédiaire de coupure de courant électrique 18, les deux cellules appartenant à des modules intermédiaires de stockage d'énergie électrique 12C-12D distincts. A l'issue de l'étape 26, l'organe 10 de mesure des tensions électriques transmet la valeur de tension électrique U1 mesurée à l'unité de commande 8.

Le procédé comporte une étape suivante 28 au cours de laquelle l'unité de commande 8 compare la valeur de tension électrique U1 mesurée aux bornes de l'organe intermédiaire de coupure de courant électrique 18 à une valeur de tension prédéterminée. Selon l'exemple de réalisation préférentiel de l'invention mentionné ci-dessus, la valeur de tension prédéterminée est égale à la seconde valeur consigne de tension prédéterminée. La valeur de tension prédéterminée est donc de préférence égale + 5V dans l'exemple de réalisation préférentiel.

Selon l'exemple de réalisation préférentiel de l'invention mentionné ci-dessus, si la valeur de tension électrique U1 mesurée aux bornes de l'organe intermédiaire de coupure de courant électrique 18 est inférieure à la valeur de tension prédéterminée (autrement dit à la seconde valeur consigne de tension prédéterminée), en particulier si cette valeur de tension U1 mesurée est nulle, alors le procédé comporte une étape suivante 30 au cours de laquelle l'unité de commande 8 détecte un état fermé bloqué de l'organe intermédiaire de coupure de courant électrique 18. Une alerte « défaut » est alors par exemple remontée par l'unité de commande 8 vers un système de supervision des composants électroniques du véhicule (non représenté).

Si la valeur de tension électrique U1 mesurée aux bornes de l'organe intermédiaire de coupure de courant électrique 18 est égale à la valeur de tension prédéterminée (autrement dit à la seconde valeur consigne de tension prédéterminée), alors aucun défaut n'est détecté par l'unité de commande 8 (ce qui signifie que l'organe intermédiaire de coupure de courant électrique 18 est bien dans son état « ouvert », conformément à la commande initiale effectuée pendant la phase 20 par l'unité de commande 8). Le procédé comporte alors une étape 32 au cours de laquelle l'unité de commande 8 procède à sa mise en sommeil. Cette situation est illustrée sur la courbe C1 de la figure 3, qui montre que l'organe intermédiaire de coupure de courant électrique 18 est bien dans son état « ouvert » au moment de l'étape 28. La courbe C4 représente l'évolution, en fonction du temps, de la tension électrique U1 mesurée aux bornes de l'organe intermédiaire de coupure de courant électrique 18. Sur cette courbe C4 on peut voir que, pendant l'étape de comparaison 28 du procédé, la tension électrique U1 mesurée aux bornes de l'organe intermédiaire de coupure de courant électrique 18 est égale à + 5V (autrement dit à la valeur de tension prédéterminée). Ceci permet à l'unité de commande 8 de détecter que l'organe intermédiaire de coupure de courant électrique 18 est bien dans son état « ouvert ». Dans le cas contraire (non représenté), la courbe C4 est plate et située sur le niveau 0 V, ce qui indique que l'organe intermédiaire de coupure de courant électrique 18 est dans l'état fermé bloqué.

Le procédé selon l'invention est simple, sécurisé et fiable, permet de réduire les coûts et ne nécessite pas de recourir à un ou plusieurs composant(s) additionnel(s) ni d'ajouter quelque contrainte sécuritaire que ce soit sur le montage.

## Revendications

1. Procédé de détection d'un état fermé bloqué d'un organe intermédiaire de coupure de courant électrique (18) d'une batterie électrique (2) d'un véhicule, la batterie électrique (2) comprenant :
- l'organe intermédiaire de coupure de courant électrique (18),
- une borne positive (14A) et une borne négative (14B) reliées à un convertisseur (6) de tension réversible du véhicule couplant une première tension de la batterie avec une seconde tension d'un réseau électrique du véhicule,
- un ensemble de modules de stockage d'énergie électrique (12, 12A-12D) reliés en série, chaque module de stockage d'énergie électrique (12, 12A-12D) comportant plusieurs cellules de stockage d'énergie électrique, l'organe intermédiaire de coupure de courant électrique (18) étant connecté en série entre deux modules intermédiaires de stockage d'énergie électrique (12C-12D),
- un premier organe de coupure de courant électrique (16A) connecté en série entre l'ensemble des modules et la borne positive (14A), et
- un second organe de coupure de courant électrique (16B) connecté en série entre l'ensemble des modules et la borne négative (14B),
le véhicule comprenant en outre une unité (8) de commande de la batterie électrique (2) et des organes de coupure (18, 16A) propre à mettre en œuvre le procédé et comprenant un organe (10) de mesure des tensions électriques aux bornes des cellules de stockage d'énergie électrique, l'organe intermédiaire de coupure de courant électrique (18) et le premier organe de coupure de courant électrique (16A) étant initialement fermés pendant une phase initiale (20) du procédé, l'organe intermédiaire de coupure de courant électrique (18) et le premier organe de coupure de courant électrique (16A) étant commandés en ouverture par l'unité de commande (8) à l'issue de la phase initiale (20), **caractérisé en ce que** le procédé exécute les étapes successives suivantes :
- une commande de fonctionnement du convertisseur (6) élevant la tension de la batterie électrique (2), à une valeur consigne de tension prédéterminée et pour une durée prédéterminée, puis pendant cette durée :
o une mesure (26) d'une valeur de tension électrique (U1) aux bornes de l'organe intermédiaire de coupure de courant électrique (18), puis
o une comparaison (28) entre la valeur de tension électrique mesurée (U1) d'une part, et une valeur de tension prédéterminée d'autre part ; puis
o en fonction du résultat de la comparaison (28), une détermination (30) d'un état fermé bloqué de l'organe intermédiaire de coupure de courant électrique (18),
la valeur consigne de tension prédéterminée se décomposant comme une somme d'une première valeur consigne de tension prédéterminée et d'une seconde valeur consigne de tension prédéterminée, la première valeur consigne de tension prédéterminée étant égale à la valeur de tension nominale de la batterie électrique (2), et **en ce que** la valeur de tension prédéterminée utilisée lors de l'étape de comparaison (28) est égale à la seconde valeur consigne de tension prédéterminée, l'unité de commande (8) détectant (30) un état fermé bloqué de l'organe intermédiaire de coupure de courant électrique (18) si la valeur de tension électrique (U1) mesurée aux bornes de l'organe intermédiaire de coupure de courant électrique (18) est inférieure à la valeur de tension prédéterminée, en particulier si la valeur de tension électrique (U1) mesurée aux bornes de l'organe intermédiaire de coupure de courant électrique (18) est nulle.

2. Procédé selon la revendication 1, **caractérisé en ce que** la seconde valeur consigne de tension prédéterminée et/ou la durée prédéterminée sont calibrables par un utilisateur.

3. Procédé selon la revendication 1 ou 2, **caractérisé en ce que** la seconde valeur consigne de tension prédéterminée est égale à + 5V.

4. Procédé selon l'une quelconque des revendications 1 à 3, **caractérisé en ce que** le procédé comporte en outre une étape (32) de mise en sommeil de l'unité de commande (8), ladite étape (32) de mise en sommeil étant effectuée en fonction du résultat de la comparaison (28).

5. Procédé selon l'une quelconque des revendications 1 à 4, **caractérisé en ce que** l'organe intermédiaire de coupure de courant électrique (18) et les premier et second organes de coupure de courant électrique (16A, 16B) sont des relais électromécaniques.

## Patentansprüche

1. Verfahren zum Erkennen eines blockiert geschlossenen Zustands eines zwischengeordneten elektrischen Stromunterbrechungselements (18) einer elektrischen Batterie (2) eines Fahrzeugs, wobei die elektrische Batterie (2) umfasst:
- das zwischengeordnete elektrische Stromunterbrechungselement (18),
- einen positiven Anschluss (14A) und einen negativen Anschluss (14B), die mit einem reversiblen Spannungswandler (6) des Fahrzeugs verbunden sind, der eine erste Spannung der Batterie mit einer zweiten Spannung eines elektrischen Bordnetzes des Fahrzeugs koppelt,
- eine Gruppe von elektrischen Energiespeichermodulen (12, 12A-12D), die in Reihe geschaltet sind, wobei jedes elektrische Energiespeichermodul (12, 12A-12D) mehrere elektrische Energiespeicherzellen umfasst, wobei das zwischengeordnete elektrische Stromunterbrechungselement (18) in Reihe zwischen zwei zwischengeordneten elektrischen Energiespeichermodulen (12C-12D) geschaltet ist,
- ein erstes elektrisches Stromunterbrechungselement (16A), das in Reihe zwischen der Gruppe der Module und dem positiven Anschluss (14A) geschaltet ist, und
- ein zweites elektrisches Stromunterbrechungselement (16B), das in Reihe zwischen der Gruppe der Module und dem negativen Anschluss (14B) geschaltet ist,
Wobei das Fahrzeug ferner eine Steuereinheit (8) der elektrischen Batterie (2) und der Stromunterbrechungselemente (18, 16A) umfasst, die zur Durchführung des Verfahrens geeignet ist und ein Element (10) zur Messung der elektrischen Spannungen an den Anschlüssen der elektrischen Energiespeicherzellen umfasst, wobei das zwischengeordnete elektrische Stromunterbrechungselement (18) und das erste elektrische Stromunterbrechungselement (16A) während einer Anfangsphase (20) des Verfahrens zunächst geschlossen sind, wobei das zwischengeordnete elektrische Stromunterbrechungselement (18) und das erste elektrische Stromunterbrechungselement (16A) am Ende der Anfangsphase (20) von der Steuereinheit (8) geöffnet angesteuert werden, **dadurch gekennzeichnet, dass** das Verfahren die folgenden aufeinanderfolgenden Schritte ausführt:
- eine Ansteuerung des Spannungswandlers (6), welche die Spannung der elektrischen Batterie (2) auf einen vorbestimmten Spannungssollwert für eine vorbestimmte Dauer erhöht, und während dieser Dauer:
∘ eine Messung (26) eines elektrischen Spannungswertes (U1) an den Anschlüssen des zwischengeordneten elektrischen Stromunterbrechungselements (18), dann
∘ einen Vergleich (28) zwischen dem gemessenen elektrischen Spannungswert (U1) einerseits und einem vorbestimmten Spannungswert andererseits; dann
∘ abhängig vom Ergebnis des Vergleichs (28) eine Bestimmung (30) eines blockiert geschlossenen Zustands des zwischengeordneten elektrischen Stromunterbrechungselements (18),
Wobei sich der vorbestimmte Spannungssollwert als Summe eines ersten vorbestimmten Spannungssollwertes und eines zweiten vorbestimmten Spannungssollwertes zusammensetzt, wobei der erste vorbestimmte Spannungssollwert dem Nennspannungswert der elektrischen Batterie (2) entspricht, und wobei der beim Vergleichsschritt (28) verwendete vorbestimmte Spannungswert dem zweiten vorbestimmten Spannungssollwert entspricht, wobei die Steuereinheit (8) einen blockiert geschlossenen Zustand des zwischengeordneten elektrischen Stromunterbrechungselements (18) erkennt (30), wenn der an dessen Anschlüssen gemessene elektrische Spannungswert (U1) kleiner als der vorbestimmte Spannungswert ist, insbesondere wenn der gemessene elektrische Spannungswert (U1) null ist.

2. Verfahren nach Anspruch 1, **dadurch gekennzeichnet, dass** der zweite vorbestimmte Spannungssollwert und/oder die vorbestimmte Dauer durch einen Benutzer kalibrierbar sind.

3. Verfahren nach Anspruch 1 oder 2, **dadurch gekennzeichnet, dass** der zweite vorbestimmte Spannungssollwert +5 V beträgt.

4. Verfahren nach einem der Ansprüche 1 bis 3, **dadurch gekennzeichnet, dass** das Verfahren ferner einen Schritt (32) des Versetzens der Steuereinheit (8) in einen Schlafmodus umfasst, wobei der Schritt (32) in Abhängigkeit vom Ergebnis des Vergleichs (28) durchgeführt wird.

5. Verfahren nach einem der Ansprüche 1 bis 4, **dadurch gekennzeichnet, dass** das zwischengeordnete elektrische Stromunterbrechungselement (18) sowie das erste und das zweite elektrische Stromunterbrechungselement (16A, 16B) elektromechanische Relais sind.

## Claims

1. Method for detecting a stuck closed state of an intermediate electric current interruption device (18) of an electric battery (2) of a vehicle, the electric battery (2) comprising:
- the intermediate electric current interruption device (18),
- a positive terminal (14A) and a negative terminal (14B) connected to a reversible voltage converter (6) of the vehicle coupling a first voltage of the battery with a second voltage of an electrical network of the vehicle,
- a set of electrical energy storage modules (12, 12A-12D) connected in series, each electrical energy storage module (12, 12A-12D) comprising a plurality of electrical energy storage cells, the intermediate electric current interruption device (18) being connected in series between two intermediate electrical energy storage modules (12C-12D),
a first electric current interruption device (16A) connected in series between the set of modules and the positive terminal (14A), and
- a second electric current interruption device (16B) connected in series between the set of modules and the negative terminal (14B),
the vehicle further comprising a control unit (8) of the electric battery (2) and of the interruption devices (18, 16A) suitable for implementing the method and comprising a device (10) for measuring the electrical voltages at the terminals of the electrical energy storage cells, the intermediate electric current interruption device (18) and the first electric current interruption device (16A) being initially closed during an initial phase (20) of the method, the intermediate electric current interruption device (18) and the first electric current interruption device (16A) being controlled to open by the control unit (8) at the end of the initial phase (20), **characterized in that** the method executes the following successive steps:
- a control of operation of the converter (6) increasing the voltage of the electric battery (2) to a predetermined voltage setpoint value and for a predetermined duration, then during this duration:
∘ a measurement (26) of an electrical voltage value (U1) at the terminals of the intermediate electric current interruption device (18), then
∘ a comparison (28) between the measured electrical voltage value (U1) on the one hand, and a predetermined voltage value on the other hand; then depending on the result of the comparison (28), a determination (30) of a stuck closed state of the intermediate electric current interruption device (18),
the predetermined voltage setpoint value being decomposed as a sum of a first predetermined voltage setpoint value and a second predetermined voltage setpoint value, the first predetermined voltage setpoint value being equal to the nominal voltage value of the electric battery (2), and **in that** the predetermined voltage value used during the comparison step (28) is equal to the second predetermined voltage setpoint value, the control unit (8) detecting (30) a stuck closed state of the intermediate electric current interruption device (18) if the electrical voltage value (U1) measured at the terminals of the intermediate electric current interruption device (18) is lower than the predetermined voltage value, in particular if the electrical voltage value (U1) measured at the terminals of the intermediate electric current interruption device (18) is zero.

2. Method according to claim 1, **characterized in that** the second predetermined voltage setpoint value and/or the predetermined duration are calibratable by a user.

3. Method according to claim 1 or 2, **characterized in that** the second predetermined voltage setpoint value is equal to +5 V.

4. Method according to any one of claims 1 to 3, **characterized in that** the method further comprises a step (32) of putting the control unit (8) into sleep mode, said sleep step (32) being carried out depending on the result of the comparison (28).

5. Method according to any one of claims 1 to 4, **characterized in that** the intermediate electric current interruption device (18) and the first and second electric current interruption devices (16A, 16B) are electromechanical relays.
